# EUROPÄISCHE PATENTANMELDUNG

(11) **EP 0 712 151 A1**
(43) Veröffentlichungstag der Anmeldung: **15.05.1996**
(21) Anmeldenummer: 95117142.0
(22) Anmeldetag: 31.10.1995
(51) Int. Cl.: H01L 21/225, H01L 21/331

(54) **Verfahren zur Einstellung der Stromverstärkung von Polyemitter-Bipolartransistoren**

(30) Priorität: 11.11.1994 DE 4440377
(71) Anmelder: SIEMENS AKTIENGESELLSCHAFT, D-80333 München (DE)
(72) Erfinder: Mahnkopf, Reinhard, D-81479 München (DE); Bianco, Michael, D-81737 München (DE)

(57) **Zusammenfassung**

Verfahren, bei dem vor dem Abscheiden eines Polysilizium-Emitters auf Bipolartransistoren die Oberfläche des Monosiliziums von Oxid befreit wird, dann die Transistoren bei niedriger Temperatur in einen Polysilizium-Ofen eingefahren werden, die Transistoren eine bestimmte Verweildauer lang dem Sauerstoff der in dem Ofen befindlichen Raumluft ausgesetzt werden und dann nach Evakuieren des Ofens die Abscheidung des Polysiliziums vorgenommen wird. Durch die Reaktion des Monosiliziums mit dem Sauerstoff im Innern des Ofens vor der Evakuierung kann eine Oxidschicht definierter Dicke vor dem Abscheiden des Polysiliziums hergestellt werden, wodurch die Stromverstärkung des fertigen Transistors gezielt eingestellt werden kann.

## Beschreibung

Bei Bipolartransistoren auf Silizium mit einem Emitter aus Polysilizium ist die Stromverstärkung, d. h. das Verhältnis von Kollektor- zu Basisstrom, im wesentlichen durch zwei Einflüsse bestimmt. Das Dotierstoffprofil des Transistors bestimmt im wesentlichen den Kollektorstrom. Die Grenzfläche zwischen Polysilizium und Monosilizium des Emitters bestimmt im wesentlichen den Basisstrom. Bei den heutigen Technologien zur Herstellung von Bipolartransistoren auf Silizium wird im allgemeinen folgendes Vorgehen praktiziert:
Das Dotierstoffprofil wird so eingestellt, daß es den elektrischen Anforderungen genügt. Die Grenzfläche zwischen Polysilizium und Monosilizium unterliegt danach der folgenden Behandlung:
Vor der Abscheidung des Polysiliziums wird ein Ätzschritt (zumeist naßchemisch) durchgeführt, um etwaiges Oxid, das sich auf der Oberfläche des Monosiliziums gebildet haben könnte, zu entfernen. Nach dieser Ätzung werden die Zwischenprodukte der Transistoren, in der Regel Halbleiterscheiben, zur Polysiliziumabscheidung gegeben. In der dafür vorgesehenen Vorrichtung, der Einfachheit halber im folgenden als Polysilizium-Ofen bezeichnet, werden die Siliziumscheiben bei niedriger Temperatur möglichst schnell eingefahren, um ein erneutes Oxidieren der Oberfläche des Monosiliziums vor der Abscheidung des Polysiliziums möglichst zu vermeiden. Dabei ergibt sich trotzdem zwischen Mono- und Polysilizium ein Grenzoxid unbestimmter Dicke, welches bei späteren Temperaturschritten mehr oder weniger stark aufbricht und die Stromverstärkung der Transistoren in nicht vorhersehbarer Weise bestimmt. Falls diese Stromverstärkung nicht dem gewünschten Wert entspricht, wird sie über eine Änderung des Dotierstoffprofils entsprechend anders eingestellt. Das läuft jedoch zumeist den übrigen elektrischen Anforderungen, die an den Transistor gestellt werden, zuwider, weil das anfänglich daraufhin optimierte Dotierstoffprofil nachträglich geändert worden ist. Das Dotierstoffprofil und die Stromverstärkung des Transistors können daher nicht unabhängig voneinander optimiert werden.

Dieser beschriebene Nachteil bei herkömmlichen Herstellungsverfahren wird entweder in Kauf genommen, wobei der Transistor hinsichtlich der gewünschten Stromverstärkung optimiert wird, oder es erfolgt eine Polysiliziumabscheidung in einer sogenannten "cluster tool"-Anlage, wie sie z. B. von der niederländischen Firma ASM INTERNATIONAL als Anlage "Advance 600/2" vorgestellt worden ist. Dabei werden in derselben Anlage nacheinander ein Oxid auf der Monosiliziumschicht entfernt, mittels einer gezielten thermischen Oxidation ein Oberflächenoxid definierter Dicke hergestellt und anschließend das Polysilizium abgeschieden. Der Transport der Halbleiterscheiben zwischen den verschiedenen Kammern der Anlage erfolgt im Vakuum, wodurch eine unerwünschte Oxidation des Siliziums vermieden wird. Durch die Dicke des Grenzoxides kann die Stromverstärkung gezielt eingestellt werden, ohne daß sich an dem Dotierstoffprofil etwas ändert. Der technische Aufwand einer derartigen Anlage ist erheblich, woraus extrem hohe Anschaffungskosten resultieren.

Aufgabe der vorliegenden Erfindung ist es, ein Verfahren zur Herstellung von Bipolartransistoren mit Polysiliziumemitter anzugeben, das bei geringem technischem Aufwand die gleichzeitige Optimierung der Stromverstärkung und des Dotierstoffprofiles ermöglicht.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren können die bisher verwendeten konventionellen Anlagen verwendet werden. Das Verfahren ermöglicht es, eine Oxidschicht an der Grenze zwischen dem Monosilizium und dem Polysilizium gezielt in einer solchen Dicke herzustellen, daß der fertiggestellte Transistor eine Stromverstärkung aufweist, die mit geringen Toleranzen bei einem vorgegebenen Wert liegt.

Bei dem erfindungsgemäßen Verfahren wird wie bisher eventuell vorhandenes Oxid auf der Oberfläche, auf die Polysilizium abgeschieden werden soll, entfernt. Möglichst unmittelbar anschließend werden die Zwischenprodukte der Transistoren, also z. B. die Halbleiterscheiben, bei niedriger Temperatur in den Polysilizium-Ofen eingefahren. Unter niedriger Temperatur ist hierbei eine Temperatur zu verstehen, die so niedrig ist, daß nach Möglichkeit ein erneutes Oxidieren der zuvor gereinigten Oberfläche vermieden wird. Wenn die Zwischenprodukte im Ofen angelangt sind und dort von Raumluft, die Sauerstoff enthält, umgeben sind, wird der Ofen nach außen luftdicht verschlossen. Die Zwischenprodukte werden eine bestimmte Zeit im Innern des Ofens gelassen, so daß die Oberfläche des Monosiliziums mit dem im Ofen vorhandenen Sauerstoff reagiert. Diese Reaktion wird beendet, indem der Ofen evakuiert wird. Die Oxidation kann ggf. durch eine Temperaturerhöhung beschleuigt werden. Temperatur und Dauer der Oxidation werden so bemessen, daß die Dicke der sich an der Oberfläche des Monosiliziums bildenden Oxidschicht Transistoren liefert, deren Stromverstärkung einen vorgegebenen Wert aufweisen oder deren Stromverstärkung zumindest in einem Toleranzbereich um diesen Wert liegt.

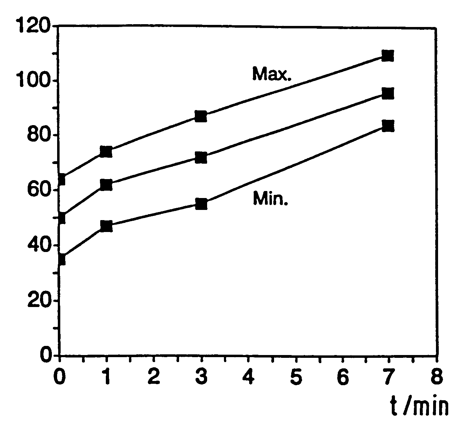

In der beigefügten Figur ist ein Diagramm abgebildet, bei dem auf der Ordinate die Stromverstärkung und auf der Abszisse die Reaktionsdauer t in Minuten abgetragen sind. Die Reaktionszeit ist die Verweilzeit der Transistor-Zwischenprodukte im Ofen ab dem Verschließen des Ofens bis zur Evakuierung. An dem Diagramm ist zu erkennen, daß bei Anwendung des erfindungsgemäßen Verfahrens die Stromverstärkung auch in herkömmlichen Anlagen im technisch interessanten Bereich problemlos eingestellt werden kann, sowohl im Hinblick auf die Genauigkeit der Einstellung als auch im Hinblick auf die erzielte Homogenität der eingestellten Stromverstärkung über die Gesamtheit der auf einer Halbleiterscheibe hergestellten Transistoren. Die obere Kurve in dem Diagramm gibt die maximale Stromverstärkung, die untere Kurve die minimale Stromverstärkung und die mittlere Kurve die mittlere Stromverstärkung einer Gesamtheit von Transistoren an, die jeweils während der auf der Abszisse angegebenen Dauer der Reaktion des Luftsauerstoffes mit der Oberfläche des Monosiliziums bei einer Temperatur von 500°C und einem Druck von 1 bar ausgesetzt waren. Wie erkennbar wird unter den angegebenen Bedingungen eine nennenswerte Erhöhung der Stromverstärkung bereits bei einer Reaktionszeit von mindestens 1 Minute erreicht. Mit dem erfindungsgemäßen Verfahren ergibt sich eine uneingeschränkte Flexibilität bei der Prozeßführung und -entwicklung, weil vorhandene, konventionelle und kostengünstige Geräte im Zusammenhang mit bereits bekannten Prozessen ohne Einschränkung einsetzbar sind und keine Spezialausrüstungen z. B. für cluster-tool-Anlagen angeschafft werden müssen.

## Patentansprüche

1. Verfahren zur Herstellung von Bipolartransistoren mit Polysilizium-Emitter, bei dem das Aufbringen des für den Emitter vorgesehenen Polysiliziums auf ein Zwischenprodukt eines herzustellenden Transistors erfolgt, indem:
a) in einem ersten Schritt alles vorhandene Oxid von einer Oberfläche dieses Zwischenproduktes, auf die Polysilizium abgeschieden werden soll, entfernt wird;
b) in einem zweiten Schritt das Zwischenprodukt bei einer Temperatur, die so niedrig ist, daß ein erneutes Oxidieren dieser Oberfläche nach Möglichkeit unterbunden ist, in eine für das Abscheiden von Polysilizium vorgesehene und mit Raumluft mit Gehalt an Sauerstoff gefüllte Vorrichtung verbracht wird;
c) in einem dritten Schritt diese Vorrichtung luftdicht verschlossen wird;
d) in einem vierten Schritt die Oberfläche des Zwischenprodukts einer Reaktion mit dem in der Vorrichtung vorhandenen Sauerstoff ausgesetzt wird, wobei Dauer und Temperatur so bemessen werden, daß sich auf der Oberfläche eine so dicke Oxidschicht bildet, daß die Stromverstärkung des fertigen Transistors dadurch zumindest näherungsweise auf einen vorgegebenen Wert festgelegt wird;
e) diese Reaktion durch Evakuieren der Vorrichtung beendet wird und dann die Abscheidung des Polysiliziums auf diese Oxidschicht erfolgt.

2. Verfahren nach Anspruch 1,
bei dem in Schritt d) die Dauer mindestens 1 Minute beträgt.

3. Verfahren nach Anspruch 1 oder 2,
bei dem in Schritt d) die Temperatur mindestens 500°C beträgt.
